Europäisches Patentamt

European Patent Office

Office européen des brevets

(19)

(11) EP 0 131 474 B2

(12) NEW EUROPEAN PATENT SPECIFICATION

(45) Date of publication and mention
of the opposition decision:
**03.04.1996 Bulletin 1996/14**

(45) Mention of the grant of the patent:
**19.09.1990 Bulletin 1990/38**

(21) Application number: **84304776.2**

(22) Date of filing: **12.07.1984**

(51) Int Cl.6: **G01R 19/165**, G05B 9/03

(54) **Control system**

Kontrollsystem

Système de contrôle

(84) Designated Contracting States:
**DE FR GB**

(30) Priority: **12.07.1983 GB 8318785**

(43) Date of publication of application:
**16.01.1985 Bulletin 1985/03**

(73) Proprietor: **HERGA ELECTRIC LIMITED**
**Bury St. Edmunds Suffolk IP32 6NN (GB)**

(72) Inventors:
• **Tracey, Peter Martin**
**Bury St. Edmunds Suffolk (GB)**
• **Oscroft, Gordon**
**Hemingford Grey Huntingdon Cambs (GB)**

(74) Representative:
**Beresford, Keith Denis Lewis et al**
**BERESFORD & Co.**
**2-5 Warwick Court**
**High Holborn**
**London WC1R 5DJ (GB)**

(56) References cited:
**DE-B- 2 258 917          GB-A- 1 594 577**
**US-A- 4 079 250**

• **JOURNAL A, vol. 24, no. 3, July 1983, pages 123-130, Antwerpen, BE; P.J. DE GROOF "Fibre sensors"**
• **IBM TECHNICAL DISCLOSURE BULLETIN, vol. 21, no. 10, March 1979, pages 3992-3993; R.W. CALLAHAN "Current/voltage variation detector"**
• **J. ACOUST: SOC. AM., vol. 67, No. 3, 1980, pp 816-818**
• **APPLIED OPTICS, vvl. 19, No. 19, 1980, pp 3265-3267**

## Description

This invention relates to a control system including sensing means for sensing a predetermined condition and providing a sensing signal, and means for monitoring the sensing signal and providing a control signal when the predetermined condition occurs.

Such a system is known from U.K. Patent No. 1567586. This patent discloses a system for the detection of broken thread or yarn, having two photosensitive elements arranged to receive light directly from a light source, and means responsive to the outputs from the photosensitive elements for indicating when a broken thread or yarn successively breaks the light paths to the two photosensitive elements. The means responsive to the two photosensitive elements comprise two comparators, each of which is coupled to both of the photosensitive elements and is arranged to indicate when the voltage output by a respective one of the two photosensitive elements falls below the voltage output by ihe other by more than a predetermined amount. Hence, the two comparators are interdependent and a failure in a circuit including either one of them may result in a false output by the other when a broken thread or yarn successively breaks the two light paths.

In a fail-to-safe control system for an apparatus of the type to which this invention more particularly relates, it is known to provide means for sensing externally applied pressure and first and second means for independently and continually monitoring the sensed pressure, each of said monitoring means providing a control signal for rendering the apparatus safe when more than a predetermined pressure is applied to the sensing means such that a failure in one of the monitoring means does not affect generation of a control signal by the other monitoring means. A number of different types of sensing means have been used in fail-to-safe control systems, namely a light-curtain arrangement, electromechanical sensors employing switches, conductive rubber mat sensors, and pneumatic pressure sensitive mat sensors. A fail-to-safe control apparatus of the above type employing pneumatic pressure sensing is disclosed in GB 1594577.

The present invention according to claim 1 is characterised in that the sensing means comprises an optical fibre, means for transmitting light through the optical fibre, means to cause the optical fibre to bend in response to applied pressure to change the amount of light transmitted therethrough, and a photodetector for detecting the amount of light transmitted through the optical fibre to generate an electrical sensing signal, and in that said first and second monitoring means are connected to receive said electrical sensing signal from the photodetector and to generate their respective control signals when the electrical sensing signal indicates that more than said predetermined pressure is applied to the sensing means.

The use of an optical fibre as a sensor is known per se, from Journal A, Vol. 24, No. 3, July 1983, pages 123 to 130, Antwerpen, BE; P.J. de Groot "Fibre Sensors", but the use of such a sensor in the type of apparatus to which the present invention relates is not known from that journal, and a number of advantages of the sensor over the known sensors used in fail-to-safe control systems are not suggested by that journal. An optical fibre hydrophone is also described in "Fiber Optic Pressure Sensor" by J N Fields et al, Journal of the Acoustical Society of America, Vol. 67, No. 3 (March 1980), pages 816 to 818.

The invention is described further, by way of example, with reference to the accompanying drawings, in which:

Fig. 1 is a diagram of a first control system according to the invention;

Fig. 2 is a graph of voltage against time representing the operation of a comparator circuit illustrated in Figure 1.

Fig. 3 is a similar graph representing operation of the comparator circuit in a different condition;

Fig. 4 is a diagrammatic view of a pressure sensitive mat embodying a sensor illustrated in Figure 1;

Figs. 5 and 6 are sections through the pressure sensitive mat showing its condition respectively when it is not and when it is compressed;

Fig. 7 is a diagram of a second control system according to the invention;

Fig. 8 is a diagram of a third control system according to the invention;

Fig. 9 is a diagram of a fourth control system according to the invention;

Fig. 10 is a diagram of a fifth control system according to the invention;

Fig. 11 is a fragmentary view of a power driven door embodying a further sensor.

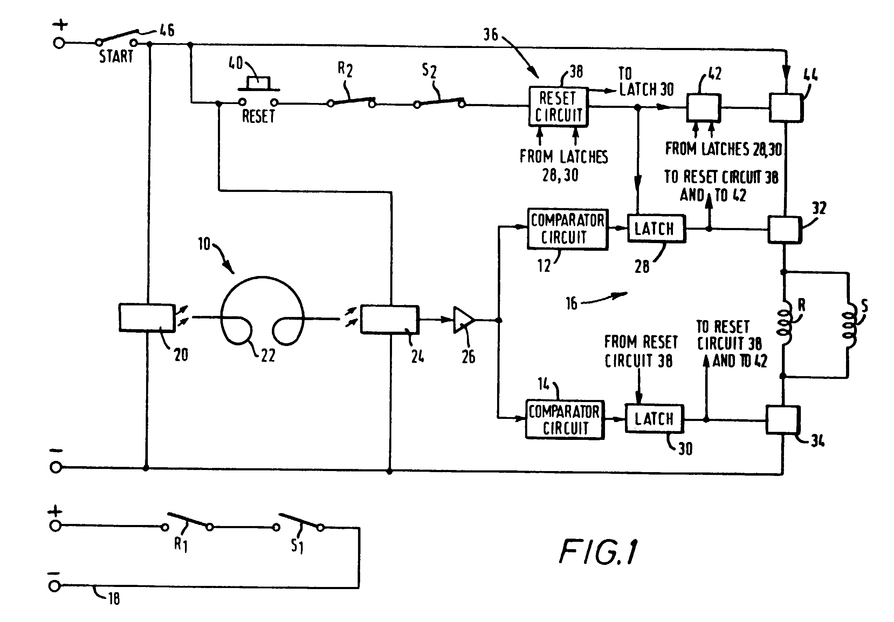

Referring initially to Figure 1, this shows a control system according to the invention including a sensor 10, a pair of comparator circuits 12, 14 for monitoring an output from the sensor 10, and control means 16 operable to produce a control signal by opening a circuit 18 to be controlled by the sensor 10.

The sensor 10 is an optical fibre sensor comprising a light source 20, such as a light emitting diode, arranged to supply light into one end of an optical fibre 22, and a light sensitive element 24 which detects the light issuing from the other end of the optical fibre 22 and generates a voltage proportional to the intensity of the light. The sensor 10 is embodied in a pressure sensitive mat described in greater detail below. In operation, the light sensitive element 24 generates a constant voltage when the mat is not compressed and a reduced voltage when the mat is compressed. An amplifier 26 is connected to the output of the sensor 10 to supply an amplified voltage V to the comparator circuits 12, 14.

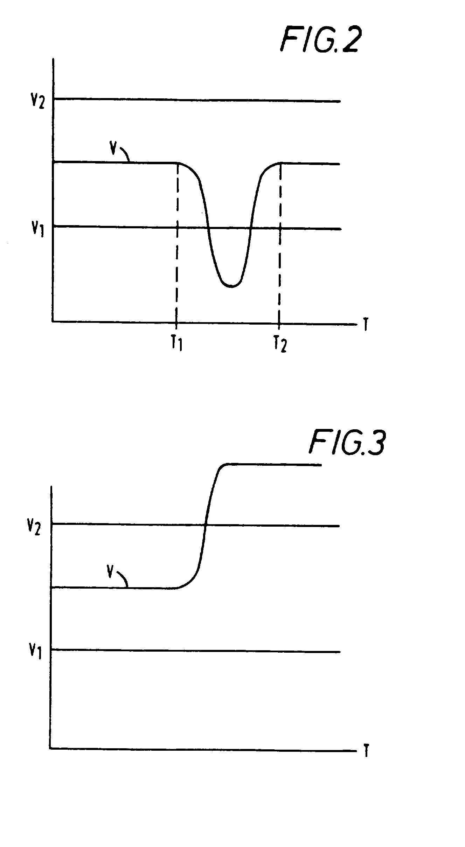

As shown in Figure 1, the comparator circuits 12 and 14 have their inputs connected to a common output of the amplifier 26. Each comparator circuit 12, 14 is adapted to compare the voltage V with a lower reference value $V_1$ and with an upper reference value $V_2$. The pair of reference values are the same for each comparator circuit. Figure 2 shows how, when the system is in use, the voltage V lies between the two reference values $V_1$ and $V_2$ during a period up until the time $T_1$ when the pressure sensitive mat is not subject to pressure, and drops temporarily below the reference value $V_1$ in the period from the time $T_1$ to $T_2$ when the mat is temporarily compressed as by a person stepping onto it. When the voltage V falls below the reference value $V_1$, both comparator circuits 12 and 14 supply signals indicating that a pre-determined condition, namely compression of the pressure sensitive mat, has occurred.

These signals serve to operate the control means 16, which comprise latches 28, 30, which are connected to the outputs of the comparator circuits 12, 14 respectively and each control a respective transistor switch 32, 34. The switches 32, 34 are in series with one another and parallel relays R, S are connected between them.

When the latches 28, 30 are enabled, they hold the transistor switches 32, 34 in the on state to permit current to flow through the switches and energize the relays R, S. On receiving the pre-determined condition indicating signals from the comparator circuits 12, 14, however, the latches 28, 30 are actuated to bring the switches 32, 34 into and hold them in the off state. The relays R, S are then de-energized.

A first contact $R_1$ of the relay R and a first contact $S_1$ of the relay S in series in the circuit 18 to be controlled are arranged to be closed when the relays R and S are energized and to be opened when the relays R and S are de-energized.

Re-setting means 36 are provided for enabling the latches 28, 30. The re-setting means 36 comprise a re-setting circuit 38 operable by a normally open re-set button 40. The re-set button 40 is connected to the re-setting circuit 38 by a series connection of a second contact $R_2$ of the relay R and a second contact $S_2$ of the relay S. These contacts are mechanically connected to the contacts $R_1$, $S_1$ respectively such that they are closed when the contacts $R_1$, $S_1$ are open and vice versa. Hence, when the relays R, S are de-energized, the contacts $R_2$, $S_2$ are closed. The re-setting circuit 38 further has first and second inputs connected to the outputs of the latches 28, 30 respectively, and first and second outputs connected to re-setting inputs of the latches for supplying signals to re-set the latches. The arrangement of the re-setting circuit 38 is such that it is actuable by the re-set button 40 to supply re-setting signals when the contacts $R_2$, $S_2$ are closed and when the outputs from the two latches 28, 30 indicate that both latches have been actuated, but not otherwise.

The re-setting circuit 38 further serves the purpose of controlling another transistor switch 44 in series with the switch 32, the parallel connection of the relays R and S, and the switch 34. More particularly, one of the outputs of the resetting circuit 38 is connected to an actuating input of a trailing edge detector 42 which operates the transistor switch 44. When the re-set button 40 is depressed to actuate the re-setting circuit 38 and is subsequently released, the result is a pulse at this output of the re-setting circuit 38. The trailing edge detector 42 responds to the trailing edge of this pulse, i.e. to release of the re-set button 40, by generating and maintaining an output which holds the transistor switch 44 in the on state. The outputs of the latches 28, 30 are connected to two further inputs of the trailing edge detector 42 and the latches 28, 30 are arranged to disable the trailing edge detector 42 when they are actuated.

A start switch 46 is provided for supplying power to the system. When the start switch 46 is open, no power is supplied and the relays R, S are de-energized. Consequently, the relay contacts $R_1$, $S_1$, are open and the relay contacts $R_2$, $S_2$, are closed.

To render the system operational, the start switch 46 is closed. Power is thus supplied to the sensor 10 and the voltage V is generated at the output of the amplifier 26. Initially, the latches 28, 30 are disabled because they automatically return to this condition when the power is shut off. Accordingly, the inputs to the re-setting circuit 38 from the latches 28, 30 are in a condition permitting actuation of the re-setting circuit 38. When the re-set button 40 is then depressed, the re-setting circuit 38 generates the re-setting signals to enable the latches 28, 30 and these switch on the transistor switches 32, 34. Subsequent release of the re-set button 40 causes the trailing edge detector 42 to place the transistor switch 44 in the on state. Current now flows through the relays R, S to energize them, and the contacts $R_1$, $S_1$ in the circuit 18 to be controlled are closed.

If, then, the pressure sensitive mat embodying the sensor 10 is compressed, the amplified sensor output voltage V falls below the reference value $V_1$ as shown in Figure 2 and the comparator circuits 12, 14 supply the signals indicative of this predetermined condition. This actuates the latches 28, 30 to switch the transistor switches 32, 34 into their off states and de-energize the relays R, S. Consequently, the contacts $R_1$, $S_1$ in the circuit 18 to be controlled are opened.

These contacts cannot then be re-closed until the latches 28, 30 have been re-set by the re-setting circuit 38. However, so long as the pressure sensitive mat remains compressed, the voltage V at the output of the amplifier 26 will remain below the reference value $V_1$ and re-setting of the latches 28, 30 will not be effective to place the transistor switches 32, 34 in their on state and energize the relays R, S.

The described control system is fail-safe under a variety of conditions.

Firstly, even if a fault occurs in the path including a respective comparator circuit, latch and transistor switch resulting in the relevant switch remaining permanently in its on state in use, the relays R, S will be de-energized when the pressure sensitive mat is compressed because the other comparator circuit detecting the drop in the voltage V below the reference value $V_1$ actuates the other latch to switch the other transistor switch into its off state.

Secondly, if a fault occurs in one of the comparator circuits or in one of the latches preventing actuation of that latch, the re-setting circuit 38 is prevented from re-setting the other latch, and the trailing edge detector 42 is prevented from returning the transistor switch 44 into its on state, and so re-energization of the relays R, S is prevented.

Thirdly, in the event that one of the relay contacts $R_1$, $S_1$ in the circuit 18 to be controlled welds closed, the other contact is still opened on de-energization of the associated relay.

Fourthly, in this event, the contact $R_2$, $S_2$ corresponding with the one which is welded closed in the circuit 18 is held open as a result of the mechanical connection between the contacts and prevents operation of the re-setting circuit 38 and re-energization of the relays R, S is prevented.

Fifthly, if on re-setting the system after de-energization of the relays R, S, the re-set button 40 is held closed, the trailing edge, detector 42 is not actuated to place the transistor switch 44 in its on condition so that the relays R, S remain de-energized.

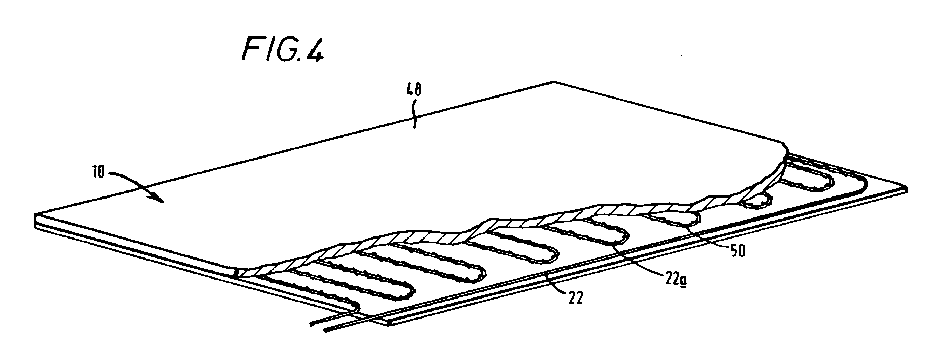

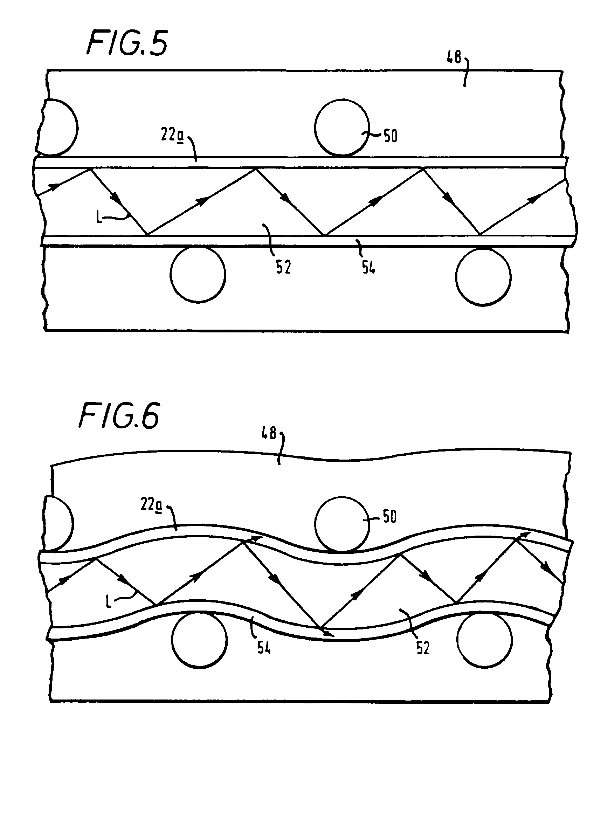

Turning to Figures 4 to 6, the sensor 10 will be described in greater detail. As mentioned above, this is embodied in a pressure sensitive mat, which is designated 48. The mat is formed from a flexible material, for example rubber, and embedded within it is a single optical fibre, the optical fibre 22. The fibre 22 includes a portion 22a arranged in a zig zag or sinuous fashion. A wire coil 50 is wound around the fibre 22 in a helical form, along the full length of the portion 22a. As shown in Figures 5 and 6, adjacent turns of the coil are spaced apart.

The fibre 22 comprises a light transmitting core 52 surrounded by a cladding 54.

When the mat is not subjected to pressure, the optical fibre lies in a plane as shown in Figure 5 and a beam of light L transmitted into the core 52 of the fibre 22 from the light source 20 undergoes total internal reflection on each occasion that it strikes the boundary surface of the core 52 and, therefore, travels along the core 52 substantially without attenuation. The light sensitive element 24 receives the light issuing from the core 52 and is thus subject to the full intensity of the light beam L. However, when the mat 48 is compressed, as by a person standing upon it, the wire in the coil 50 acting on the fibre 22 deforms it creating bends in the fibre 22 as shown in Figure 6, which are sharper than those around which the light beam L can travel. The angle of incidence of the light beam L in at least some of the places where it strikes the boundary surface of the core 52 is thus altered such that light is refracted out of the core 52 and into the cladding 54 instead of being reflected within the core 52. Consequently, the intensity of the light beam L diminishes along the length of the core 52, and the output of the light sensitive element 24 decreases accordingly. It should be noted that the light passing into the cladding 54 is not detected by the element 24.

In the event that the fibre 22 is accidentally severed and the severed ends of the fibre become offset from one another, the output from the fibre 22 to the light sensitive element 24 will be affected. For example, the light sensitive element 24 may then receive a diminished quantity of light and the voltage V at the output of the amplifier 26 may drop below the reference level $V_1$. In this instance, the comparator circuits 12, 14 respond as if the mat had been compressed and supply the signal indicative of the pre-determined condition to actuate the latches 28, 30 and de-energize the relays R, S. Alternatively, if there is an additional light source in the vicinity of the break, the light sensitive element may receive an increased quantity of light so that the voltage V at the output of the amplifier 26 rises above the reference level $V_2$. This situation is illustrated in Figure 3. In this instance also, the comparator circuits 12, 14 are adapted to generate a signal to actuate the latches 28, 30.

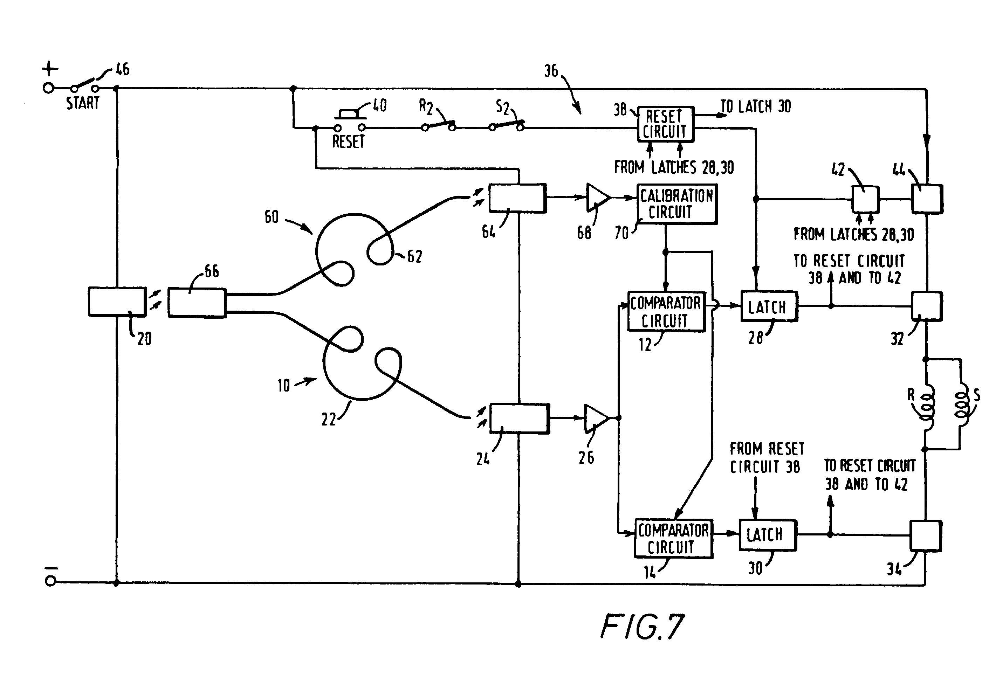

A second embodiment of the control system is shown in Figure 7. Parts of this system are the same as in the embodiment shown in Figure 1 and are designated by the same reference numerals. Only the parts which differ from the system shown in Figure 1 will be described.

As shown in Figure 7, the second embodiment of the control system includes a second or reference sensor 60 comprising a second optical fibre 62 arranged to receive light from the light source 20, and a second light sensitive element 64 for detecting light issuing from the optical fibre 62. The optical fibres 22 and 62 are connected to a Y junction 66 at their light receiving ends arranged to split the light from the light source 20 between the two fibres. By contrast with the optical fibre 22, the optical fibre 62 is not incorporated in a pressure sensitive mat and is not arranged to be deformable for attenuating the light transmitted. It serves with the light sensitive element 64 simply to provide a reference output. An amplifier 68 connected to the light sensitive element 64 is arranged to amplify this output to generate a reference voltage $V_R$ which is the same as the voltage V supplied by the amplifier 26 when the pressure sensitive mat is not compressed.

A calibration circuit 70 is connected to the output of the amplifier 68 to receive the reference voltage $V_R$ and controls the levels of the reference values $V_1$ and $V_2$ employed in the comparator circuits 12, 14 in dependence upon the level of the reference voltage $V_R$. Should the quantity of light emitted by the light source 20 vary due to aging, temperature fluctuations or some other parameter, the reference voltage $V_R$ varies accordingly and the calibration circuit 70 adjusts both reference values $V_1$ and $V_2$ up or down by a corresponding amount. Thus, this arrangement provides compensation for variations in the output of the light source 20.

The system shown in Figure 7 is of particular benefit when the light source 20 is a light emitting diode because such items are prone to the effects of aging.

In a modification of the embodiment shown in Figure 7, the optical fibre 62 is incorporated in a second pressure sensitive mat as shown in Figure 4. When this second mat is compressed, the reference voltage applied to the calibration circuit 70 falls, causing the calibration circuit 70 to adjust the reference values $V_1$ and $V_2$ employed in the comparator circuits 12, 14 downwardly. As a result, the amplified output voltage V from the sensor 10 rises above the upper reference value $V_2$, and the comparator circuit 12, 14 supplies the pre-determined condition indicating signals to the latches 28, 30. The latches 28, 30 are thereby actuated to de-energize the relays R, S.

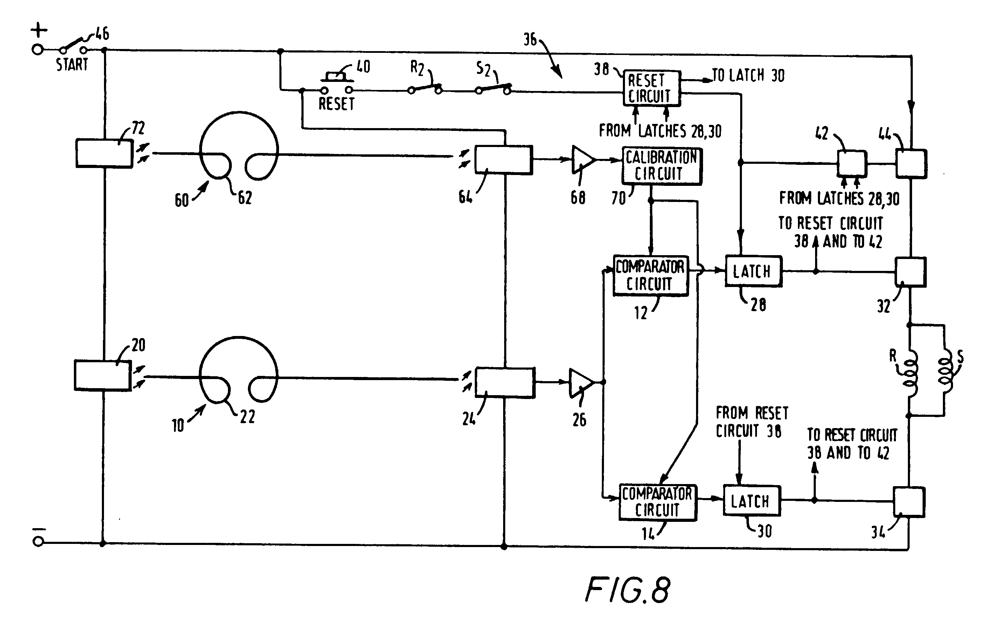

A further modification of the system of Figure 7 is shown in Figure 8. This system is the same as that of Figure 7 except in that the Y junction 66 is omitted and a second light source 72 is provided in series with the light source 20 for supplying light to the optical fibre 62. providing that the light sources 20, 72 are of the same variety and are situated in the same vicinity, they can be expected to produce similar outputs which vary, e.g. with time or temperature, at substantially the same rate, and so the reference voltage $V_R$ generated by the amplifier 68 will remain approximately the same as the voltage V supplied by the amplifier 26 when the pressure sensitive mat incorporating the sensor 10 is not compressed. Hence, this arrangement again provides compensation for variations in the output of the light source 20.

The systems of Figures 7 and 8 are fail-safe in all the situations described in relation to the system of Figure 1, and also in the event that there is a failure in the path including the fibre 62, the detector 64, and the calibration circuit 70, which causes a change in the reference voltage $V_R$ while the voltage V remains the same. In this instance, the reference values $V_1$, $V_2$ in the comparator circuits 12, 14 are adjusted and the voltage V falls below the value $V_1$ or rises above the value $V_2$ so that the comparator circuits 12, 14 cause actuation of the latches 28, 30. Re-energisation of the relays R, S is only possible once the failure has been cured.

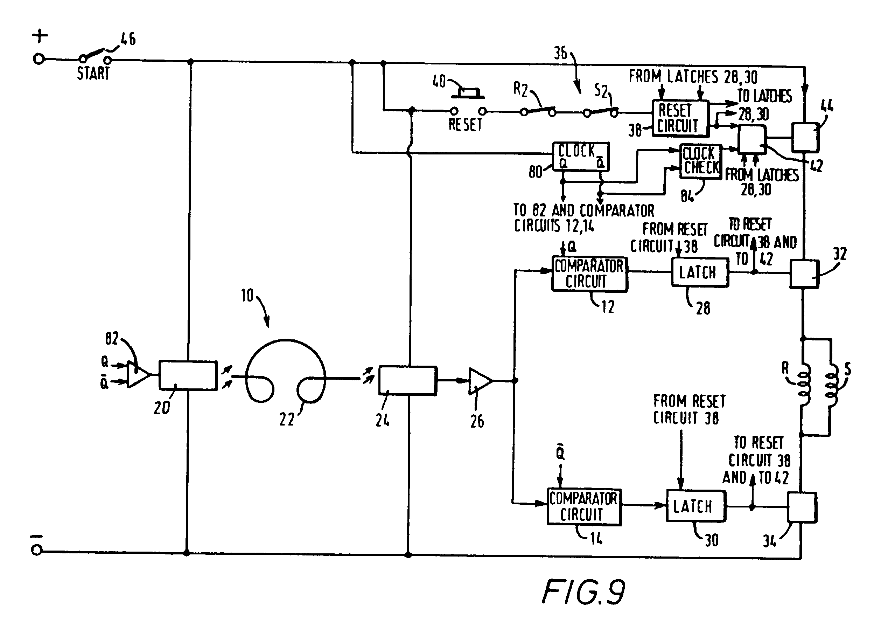

Figure 9 illustrates a further embodiment of the invention. Again, parts of this system are the same as in the embodiment shown in Figure 1 and are designated by the same reference numerals. Only the parts which differ from the system shown in Figure 1 will be described.

As shown in Figure 9, this further embodiment includes a clock 80 having outputs Q and $\overline{Q}$ for supplying alternately high and low output signals, respectively from the clock 80.

An amplifier 82, having two inputs connected respectively to the clock outputs Q and $\overline{Q}$, is connected to the light source 20 to supply an amplified clock signal to the light source. In operation, the light source 20 emits light of a periodically varying intensity, which varies in synchronism with the output from the clock 80. Therefore, when the pressure sensitive mat is not compressed, the amplifier 26 generates a voltage which varies periodically in synchronism with the output from the clock 80.

Additionally, the clock output Q is connected to the comparator 12 and the clock output $\overline{Q}$ is connected to the comparator 14, and the arrangement is such that the comparator 12 is enabled when there is a high output signal at the clock output Q and the comparator 14 is enabled when there is a low output signal at the clock output $\overline{Q}$. Hence, the comparators 12, 14 are enabled alternately in synchronism with the output from the clock 80. In this way, one comparator, the comparator 12, monitors the high level output from the amplifier 26 and the other comparator, the comparator 14, monitors the low level output from the amplifier 26. For the purpose, the reference values employed in the two comparators are pre-set accordingly so that the reference values $V_1$ and $V_2$ used in the comparator 12 are each displaced by a pre-determined amount relative to the reference values $V_3$ and $V_4$ used in the comparator 14.

A clock check circuit 84 is arranged between the clock 80 and the trailing edge detector 42 and has two inputs connected respectively to the clock outputs Q and $\overline{Q}$, and a single output connected to the trailing edge detector 42. The clock check circuit 84 monitors the output from the clock 80 and normally supplies an indication of proper operation to the trailing edge detector 42. Only when this indication is present can the trailing edge detector 42 respond to actuation of the re-set button 40 to place the transistor switch 44 in the on state. Hence, re-setting of the control system after de-energization of the relays R, S can only take place if the clock check circuit 84 indicates that the clock 80 is operating properly.

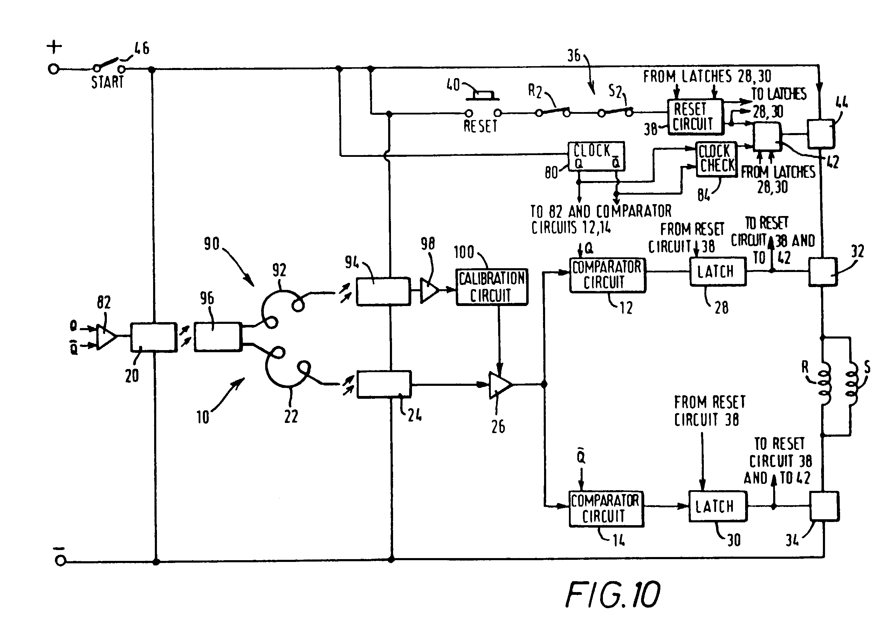

A modification of the control system illustrated in Figure 9 is shown in Figure 10 and features a reference sensor 90 comprising a second optical fibre 92 arranged to receive light from the light source 20, and a second light sensitive element 94 for detecting light issuing from the optical fibre 92. The optical fibres 22 and 92 are connected to a Y junction 96 at their light receiving ends arranged to split the light from the light source 20 between the two fibres. The optical fibre 92 may either be incorporated in a pressure sensitive mat or not as in the case of the control systems shown in Figures 7 and 8. In either case, the optical fibre 92 serves with the light sensitive element 94 to provide a reference output. An amplifier 98 connected to the light sensitive element 94 is arranged to amplify this output to generate a reference voltage Vs.

A calibration circuit 100 is connected to the output of the amplifier 98 to receive the reference voltage $V_s$ and is connected to the amplifier 26 to control the gain of this amplifier in dependence upon the level of the reference voltage $V_s$. Should the quantity of light emitted by the light source 20 vary due to aging or temperature fluctuations, for example, the reference voltage $V_s$ varies accordingly and the calibration circuit 100 adjusts the gain of the amplifier 26 to modify the output from this amplifier accordingly. Thus, this arrangement again provides compensation for variations in the output of the light source 20.

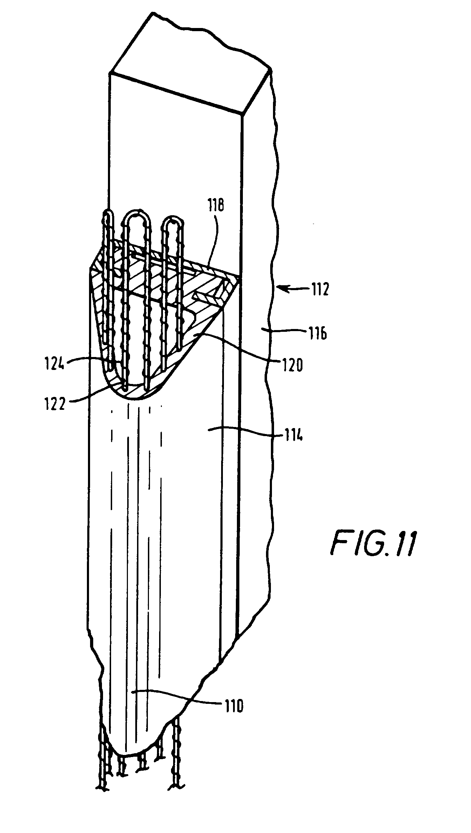

Turning to Figure 11, this illustrates another form of the sensor 10 incorporated in a pressure sensitive edge 110 of a door 112. The door 112 comprises an edge member 114 mounted on the leading edge of the main body 116 of the door. The edge member 114 includes a channel support 118 by which it is secured to the main body 116 of the door, and a tubular element 120 which is formed from a flexible material, for example, rubber, and which is mounted on the channel support 118. A single optical fibre 122 is embedded within the tubular element 120 and passes vertically up and down the exposed wall of the tubular element 120 in a sinuous fashion. A wire coil 124 is wound around the fibre 122 in a helical form with adjacent turns of the coil being spaced apart. The fibre 122 comprises a light transmitting-core encased within a cladding, although this is not shown.

The operation of the sensor in this instance is the same as described with reference to Figures 5 and 6 and so a further description is not provided.

It will be appreciated that various modifications are possible in the described systems beyond those already mentioned above.

For example, the relays R, S may be replaced by just a single relay or by three or more relays.

Also, the contacts $R_1$, $R_2$ and $S_1$, $S_2$ of each relay may be replaced by ones which are not mechanically interconnected.

Also, in the systems shown in Figures 7 and 8, the calibration circuit 70 may be employed to adjust the gain of the amplifier 26 as in the system of Figure 10.

And, in the system of Figure 10, the calibration circuit 100 could, alternatively, be connected to the comparators 12 and 14, as in the case of the systems shown in Figures 7 and 8.

Indeed, it is equally possible in the systems shown in any of Figures 7, 8 and 10, that the calibration circuit 70 or 100 should control the current supply to the light source 20.

### Claims

1. A fail-to-safe control system for an apparatus, comprising means (20, 22, 24) for sensing externally applied pressure and first and second means (12, 28, 32; 14, 30, 34) for independently and continually monitoring the sensed pressure, each of said monitoring means providing a control signal for rendering the apparatus safe when more than a predetermined pressure is applied to the sensing means such that a failure in one of the monitoring means does not affect generation of a control signal by the other monitoring means, characterised in that the sensing means comprises an optical fibre (22), means (20) for transmitting light through the optical fibre, means (50, 124) to cause the optical fibre to bend in response to applied pressure to change the amount of light transmitted therethrough, and a photodetector (24, 26) for detecting the amount of light transmitted through the optical fibre to generate an electrical sensing signal, and in that said first and second monitoring means are connected to receive said electrical sensing signal from the photodetector and to generate their respective control signals when the electrical sensing signal indicates that more than said predetermined pressure is applied to the sensing means.

2. A control system according to claim 1, characterised in that the optical fibre is provided in a safety mat (48) to form a two-dimensional sensing area.

3. A control system according to claim 1, characterised in that the optical fibre is provided in an elongate member to form a pressure sensitive edge (110).

### Patentansprüche

1. Sicherheits-Steuersystem für ein Gerät, umfassend eine Einrichtung (20, 22, 24) zur Erfassung eines von außen angelegten Drucks sowie eine erste und eine zweite Einrichtung (12, 28, 32; 14, 30, 34) zur unabhängigen und kontinuierlichen Überwachung des erfaßten Drucks, wobei jede der Überwachungseinrichtungen ein Steuersignal liefert, um das Gerät bei Einwirken eines über einem vorgegebenen Wert liegenden Drucks auf die Erfassungseinrichtung derart sicher zu schalten, daß ein Fehler in einer der Überwachungseinrichtungen die Erzeugung eines Steuersignals durch die andere Überwachungseinrichtung nicht beeinträchtigt, dadurch gekennzeichnet, daß die Erfassungseinrichtung eine optische Faser (22), eine Einrichtung (20) zur Übertragung von Licht durch die optische Faser, eine Einrichtung (50, 124), die bewirkt, daß sich die optische Faser bei Druckeinwirkung biegt und die durch sie übertragene Lichtmenge ändert sowie einen Photodetektor (24, 26) zur Erfassung der durch die optische Faser übertragenen Lichtmenge und Erzeugung eines elektrischen Erfassungssignals umfaßt und daß die erste und die zweite Überwachungseinrichtung so angeschlossen sind, daß sie das elektrische Erfassungssignal von dem Photodetektor empfangen und ihre entsprechenden Steuersignale erzeugen, wenn das elektrische Erfassungssignal anzeigt, daß ein über dem vorgegebenen Wert liegender Druck auf die Erfassungseinrichtung einwirkt.

2. Steuersystem nach Anspruch 1, dadurch gekennzeichnet, daß die optische Faser unter Bildung einer zweidimensionalen Erfassungsfläche in einer Sicherheitsmatte (48) vorgesehen ist.

3. Steuersystem nach Anspruch 1, dadurch gekennzeichnet, daß die optische Faser unter Bildung einer drucksensitiven Kante (110) in einem länglichen Bauteil vorgesehen ist.

**Revendications**

1. Système de contrôle de défaut-sécurité pour un appareil, ce système comprenant des moyens (20, 22, 24) pour détecter une pression appliquée de l'extérieur, ainsi qu'un premier et un second dispositif (12, 28, 32 ; 14, 30, 34) pour surveiller indépendamment et en permanence la pression détectée, chacun de ces dispositifs de surveillance fournissant un signal de commande destiné à assurer la sécurité de l'appareil lorsqu'une pression supérieure à une pression prédéterminée est appliquée aux moyens de détection, de façon qu'une panne de l'un des dispositifs de surveillance n'affecte pas la production d'un signal de commande par l'autre dispositif de surveillance, système caractérisé en ce que les moyens de détection comprennent une fibre optique (22), des moyens (20) pour émettre de la lumière dans la fibre optique, des moyens (50, 124) pour produire une courbure de la fibre optique en réponse à une pression appliquée, de manière à modifier la quantité de lumière transmise par la fibre optique, et un photodétecteur (24, 26) pour détecter la quantité de lumière transmise par la fibre optique de manière à générer un signal électrique de détection, et en ce que le premier et le second dispositif de surveillance sont branchés pour recevoir le signal électrique de détection provenant du photodétecteur et pour générer leurs signaux de contrôle respectifs lorsque le signal électrique de détection indique qu'une pression supérieure à la pression prédéterminée est appliqué aux moyens de détection.

2. Système de contrôle selon la revendication 1, caractérisé en ce que la fibre optique est utilisée dans un tapis de sécurité (48) pour former une zone de détection à deux dimensions.

3. Système de contrôle selon la revendication 1, caractérisé en ce que la fibre optique est utilisée dans un élément allongé pour former un bord sensible à la pression (110).

FIG.1

EP 0 131 474 B2

## FIG.2

## FIG.3

FIG.4

FIG.5

FIG.6

FIG.7

EP 0 131 474 B2

FIG.8

EP 0 131 474 B2

FIG.9

FIG.10

EP 0 131 474 B2

FIG.11